# EUROPEAN PATENT APPLICATION

(11) **EP 2 752 455 A1**
(43) Date of publication of application: **09.07.2014**
(21) Application number: 12827752.2
(22) Date of filing: 22.08.2012
(51) Int. Cl.: C08L 67/00, C08L 23/00, C08L 61/04, C08L 63/00, H01L 23/29, H01L 23/31

(54) **RESIN COMPOSITION FOR SEALING ELECTRICAL AND ELECTRONIC PARTS, METHOD FOR PRODUCING SEALED ELECTRICAL AND ELECTRONIC PARTS, AND SEALED ELECTRICAL AND ELECTRONIC PARTS**

(30) Priority: 30.08.2011 JP 2011186937; 26.12.2011 JP 2011283624
(71) Applicant: Toyobo Co., Ltd., Osaka-shi Osaka 530-8230 (JP)
(72) Inventor: FUNAOKA, Daiki, Otsu-shi Shiga 520-0292 (JP); SHIGA, Kenji, Otsu-shi Shiga 520-0292 (JP)
(74) Representative: Müller-Boré & Partner Patentanwälte PartG mbB
(86) International application number: PCT/JP2012/071154
(87) International publication number: WO 2013/031593

(57) **Abstract**

It is provided that a resin composition for sealing electrical and electronic parts that can provide a flame-retardant sealed electrical and electronic part having no bleed out of a flame resistor while maintaining filling properties of a sealant in the practical level and adhesion between the sealant and an electrical and electronic part. A resin composition for sealing electrical and electronic parts, comprising a copolymer polyester elastomer (X), a brominated epoxy resin (B1), a non-brominated epoxy resin (B2) and a polyolefin resin (C), and having a melt viscosity of 5 dPa·s or more and 3.0 × 103 dPa·s or less when dried to a water content of 0.1% or less, heated to 220°C, subjected to a pressure of 1 MPa, and then extruded from a die having a hole diameter of 1.0 mm and a thickness of 10 mm, a sealed electrical and electronic part using the resin composition for sealing electrical and electronic part, and a method for producing the sealed electrical and electronic parts.

## Description

### TECHNICAL FIELD

The present invention relates to a sealed electrical and electronic part sealed with a resin composition and a production method thereof, and a resin composition suitable for this purpose.

### BACKGROUND ART

It is indispensable for an electrical and electronic part used widely in vehicles and electrical appliances to be electrically insulated from outsides for satisfying its use purpose, and a sealing method for reliably certainly following the shape of electrical and electronic parts without leaving any unfilled portion is required. A hot melt resin whose viscosity is lowered only by heating and melting to make sealing possible has excellent characteristics such that it is solidified to form a sealed body only by cooling after sealing, thus productivity is high, a member can be easily recycled by melting and removing a resin by heating, and the like, thus is suitable for sealing electrical and electronic parts.

A polyester having both high electric insulation and water resistance is considered to be a very useful material for this purpose, but generally has a high melt viscosity, and requires injection molding at a high pressure of several hundreds MPa or more to seal complicated shape parts, and there is a risk of breaking an electrical and electronic part. Regarding this, Patent Document 1 discloses a polyester resin composition for molding containing a polyester resin having specific composition and physical properties and an antioxidant, and discloses that sealing at a low pressure in which an electrical and electronic part is not damaged is possible. According to this resin composition, a molded product having good initial bond property is obtained, and application of a polyester-based resin composition to a general electrical and electronic part is possible. In addition, Patent Document 2 discloses a resin composition for sealing electrical and electronic parts in which a crystalline polyester resin, an epoxy resin and a polyolefin resin are blended. This composition has high initial adhesion strength to a glass epoxy plate and a polybutylene terephthalate plate containing 30% by weight of a glass filler, and lowering of bond strength by 1000 load of cooling and heating cycles at -40°C and 80°C, load at 85°C and 85% RH for 1000 hours and load at 105°C for 1000 hours has been also suppressed.

### PRIOR ART DOCUMENTS

### PATENT DOCUMENTS

Patent Document 1: JP 3553559 B1
Patent Document 2: JP-A-2010-150471

### SUMMARY OF THE INVENTION

### PROBLEMS TO BE SOLVED BY THE INVENTION

While flame retardancy may be required for a sealed electrical and electronic part, Patent Documents 1 and 2 only describe that a flame resistor can be blended, and do not suggest a specific flame retardant formulation. In order to impart flame retardancy to a sealed electrical and electronic part, a flame resistor should be blended. But, it has been found that, when an existing flame resistor is simply blended, a flame resistor is necessary to be blended in a high blending ratio in order to obtain practical flame retardancy, and the problems that flowability of a sealant is lowered to cause a filling failure of the sealant, adhesion between a sealant to an electrical and electronic part is lowered, bleed out of a flame resistor is caused and the like are caused. An object of the present invention is to provide a resin composition for sealing electrical and electronic parts that can provide a flame-retardant sealed electrical and electronic part having no bleed out of a flame resistor while maintaining filling properties of a sealant in the practical level and adhesion between the sealant and an electrical and electronic part.

### SOLUTIONS TO THE PROBLEMS

(1) A resin composition for sealing electrical and electronic parts, comprising a copolymer polyester elastomer (X), a brominated epoxy resin (B1), a non-brominated epoxy resin (B2) and a polyolefin resin (C), and having a melt viscosity of 5 dPa·s or more and 3.0 × 10³ dPa·s or less when dried to a water content of 0.1% or less, heated to 220°C, subjected to a pressure of 1 MPa, and then extruded from a die having a hole diameter of 1.0 mm and a thickness of 10 mm.
(2) A resin composition for sealing electrical and electronic parts, comprising a crystalline polyester resin (A) in which polyether diols are copolymerized, a brominated epoxy resin (B1), a non-brominated epoxy resin (B2) and a polyolefin resin (C), and having a melt viscosity of 5 dPa·s or more and 3000 dPa·s or less when dried to a water content of 0.1% or less, heated to 220°C, subjected to a pressure of 1 MPa, and then extruded from a die having a hole diameter of 1.0 mm and a thickness of 10 mm.
(3) The resin composition for sealing electrical and electronic parts according to (1) or (2), wherein both brominated the epoxy resin (B1) and the non-brominated epoxy resin (B2) are a bisphenol A type or a novolac type epoxy resin.
(4) The resin composition for sealing electrical and electronic parts according to any of (1) to (3), comprising 100 parts by mass of the copolymer polyester elastomer (X) or the crystalline polyester resin (A), a total of 5 to 100 parts by mass of the brominated epoxy resin (B1) and the non-brominated epoxy resin (B2) and 0.1 to 100 parts by mass of a polyolefin resin (C), wherein the non-brominated epoxy resin (B2) is blended in 10% by mass or more and 50% by mass or less of the brominated epoxy resin (B1).
(5) The resin composition for sealing electrical and electronic parts according to any of (1) to (4), further comprising a phenol resin and/or phenol-modified alkyl benzene resin (D).
(6) A method for producing a sealed electrical and electronic part, comprising heating and kneading the resin composition according to any of (1) to (5), and thereafter injecting the resin composition into a mold including an inserted electrical and electronic part at a resin composition temperature of 130°C or more and 260°C or less and at a resin composition pressure of 0.1 MPa or more and 10 MPa or less.
(7) A sealed electrical and electronic part sealed with the resin composition as defined in any of (1) to (5).

### EFFECTS OF THE INVENTION

The resin composition for sealing electrical and electronic parts of the present invention is used as a sealing material in a sealed electrical and electronic part, whereby a flame-retardant sealed electrical and electronic part having no bleed out of a flame resistor while maintaining filling properties of a sealant in the practical level and adhesion between the sealant and an electrical and electronic part can be obtained.

### BRIEF DESCRIPTION OF THE DRAWINGS

Fig. 1 is a schematic view showing a method for preparing a test piece for bond strength test.
Fig. 2 is a schematic view showing a method for preparing a test piece for bond strength test.
Fig. 3 is a schematic view showing a method for preparing a test piece for bond strength test.

### MODE FOR CARRYING OUT THE INVENTION

The sealed electrical and electronic part of the present invention can be produced by injecting a resin or resin composition which is heated and kneaded to provide flowability thereto into a mold in which an electrical and electronic part is set in the internal of the mold, at a low pressure of 0.1 to 10 MPa, and holding and sealing the electrical and electronic part by the resin or resin composition. More specifically, as compared to a conventional injection molding at a high pressure of 40 MPa or more generally used in the plastic molding, at much lower pressure. Thus, while sealing is provided by an injection molding method, an electrical and electronic part having limited heat resistance and pressure resistance can be sealed without being broken. A sealing resin or a sealing resin composition is suitably selected, whereby a sealed body having bond durability that endures the environmental loads and having flame retardancy, to various polyester substrates, glass epoxy substrates, metals and the like, can be obtained. Hereinafter, the details of the embodiments of the invention will be sequentially described.

### <Copolymer polyester elastomer (X)>

The copolymer polyester elastomer (X) used in the present invention comprises a chemical structure in which a hard segment mainly consisting of a polyester segment and a soft segment mainly consisting of a polycarbonate segment, a polyalkylene glycol segment and/or a polylactone segment are combined by an ester bond. It is preferred that the polyester segment mainly comprise polyester of a structure that can be formed by polycondensation of an aromatic dicarboxylic acid, an aliphatic glycol and/or an alicyclic glycol. The soft segment is contained in an amount of preferably 20% by weight or more and 80% by weight or less, more preferably 30% by weight or more and 70% by weight or less, and further preferably 40% by weight or more and 60% by weight or less, based on the whole copolymer polyester elastomer.

The lower limit of the number average molecular weight of the copolymer polyester elastomer (X) used in the present invention is not particularly limited, and is preferably from 3,000 or more, more preferably from 5,000 or more, and further preferably from 7,000 or more. In addition, the upper limit of the number average molecular weight is not particularly limited, and is preferably from 50,000 or less, more preferably from 40,000 or less, and further preferably from 30,000 or less. When the number average molecular weight is too low, hydrolysis resistance of the resin composition for sealing and high retention of elongation under high temperature and high humidity may be insufficient, and when the number average molecular weight is too high, the melt viscosity of the resin composition may be increased, and the molding pressure may be too high, and forming may be difficult.

The copolymer polyester elastomer (X) used in the present invention preferably a saturated polyester resin, and also preferably an unsaturated polyester resin having a small amount of vinyl groups of 50 equivalent/10⁶ g or less. In the case of an unsaturated polyester having a high concentration of vinyl groups, there is a possibility such that crosslinking occurs upon melting, and may have poor melt stability.

The copolymer polyester elastomer (X) used in the present invention may be a branched polyester obtained by copolymerizing polycarboxylic acids or polyols having three or more functional groups such as trimellitic anhydride and trimethylolpropane, as necessary.

In order to mold the copolymer polyester elastomer (X) used in the present invention without causing thermal degradation as much as possible, rapid melting at 210 to 240°C is required. Therefore, the upper limit of the melting point of the copolymer polyester elastomer (X) is desirably 210°C. The upper limit is preferably 200°C and more preferably 190°C. Considering handling properties at ordinary temperature and normal heat resistance, the upper limit is 70°C or more, preferably 100°C or more, further preferably 120°C or more, particularly preferably 140°C or more, and most preferably 150°C or more.

As the method for producing the copolymer polyester elastomer (X) used in the present invention, a known method can be adopted, and for example, a copolymer polyester elastomer can be obtained by esterifying the polycarboxylic acid component and the polyol component set forth below at 150 to 250°C, then polycondensing the reactant at 230 to 300°C while reducing the pressure. Alternatively, a copolymer polyester elastomer can be obtained by esterifying using a derivative such as a dimethyl ester of the polycarboxylic acid and the polyol component set forth below at 150°C to 250°C, then polycondensing the reactant at 230°C to 300°C while reducing the pressure.

Examples of the method for determining the composition and composition rate of the copolymer polyester elastomer (X) used in the present invention include ¹H-NMR and ¹³C-NMR determined by dissolving a polyester resin in a solvent such as heavy chloroform, quantitative analysis by gas chromatography determined after methanolysis of a polyester resin (hereinafter, may be abbreviated as methanolysis-GC method), and the like. In the present invention, in the case where there is a solvent that can dissolve the copolymer polyester elastomer (X) and is suitable for ¹H-NMR measurement, the composition and composition ratio shall be determined by ¹H-NMR. In the case where there is no suitable solvent, and in the case where the composition ratio cannot be specified only by ¹H-NMR measurement, ¹³C-NMR and methanolysis-GC method shall be adopted or concurrently used.

### <Hard segment of copolymer polyester elastomer (X)>

It is preferred that the hard segment of the copolymer polyester elastomer (X) of the present invention is mainly comprised of a hard segment consisting of a polyester segment.

The acid component constituting the polyester segment is not particularly limited, and it is preferred that an aromatic dicarboxylic acid of 8 to 14 carbon atoms be contained in 50% by mol or more of the total acid components, in terms of a design to have high melting point for increasing heat resistance of the copolymer polyester elastomer. In addition, when the aromatic dicarboxylic acid having 8 to 14 carbon atoms is terephthalic acid and/or naphthalenedicarboxylic acid, it is highly reactive with glycol, and is desirable in terms of polymerizability and productivity. The total of terephthalic acid and naphthalenedicarboxylic acid is more preferably 60% by mol or more, more preferably 80% by mol or more, and further preferably 95% by mol or more, of the total acid components of the copolymer polyester elastomer, and the total acid components may be constituted by terephthalic acid and/or naphthalenedicarboxylic acid.

Other acid components constituting the polyester segment include dicarboxylic acids such as aromatic carboxylic acids such as diphenyl carboxylic acid, isophthalic acid and sodium 5-sulisophthalic acid, alicyclic dicarboxylic acids such as cyclohexanedicarboxylic acid and tetrahydrophthalic anhydride, and aliphatic dicarboxylic acids such as succinic acid, glutaric acid, adipic acid, azelaic acid, sebacic acid, dodecanedioic acid, dimer acid and hydrogenated dimer acid. These dicarboxylic acids were used in the range that the melting point of the resin is not greatly lowered, and the copolymerization ratio is less than 30% by mol and preferably less than 20% by mol of the total acid components. In addition, as other acid components constituting the polyester segment, it is also possible to use a polycarboxylic acid having three or more functional groups such as trimellitic anhydride and pyromellitic acid. The copolymerization ratio of the polycarboxylic acid having three or more functional groups is preferably 10% by mol or less and more preferably 5% by mol or less, from the viewpoint of inhibiting gelation of the resin composition.

In addition, the aliphatic glycol or alicyclic glycol constituting the polyester segment is not particularly limited, but preferably contains 50% mol or more of the aliphatic glycol and/or alicyclic glycol having 2 to 10 carbon atoms based on the total glycol components, and more preferably comprises alkylene glycols having 2 to 8 carbon atoms. Specific examples of the preferred glycol components include ethylene glycol, 1,3-propylene glycol, 1,4-butanediol, 1,6-hexanediol, 1,4-cyclohexanedimethanol, and the like. 1,4-Butanediol and 1,4-cyclohexanedimethanol are most preferable in terms of a design to have high melting point for increasing heat resistance of the polyester elastomer. Also, as a part of the glycol component, the polyols having three or more functional groups such as glycerin, trimethylolpropane and pentaerythritol may be used, the ratio is preferably 10% by mol or less and more preferably 5% by mol or less, from the viewpoint of inhibiting gelation of the resin composition.

As the component constituting the polyester segment, those consisting of a butylene terephthalate unit or a butylene naphthalate unit are particularly preferred, in terms of capable of making the melting point of the polyester elastomer higher to increase heat resistance and also moldability and cost performance.

### <Soft segment of copolymer polyester elastomer (X)>

It is preferred that the soft segment of the copolymer polyester elastomer (X) of the present invention mainly comprise a soft segment mainly consisting of a polycarbonate segment, a polyalkylene glycol segment, and/or a polylactone segment. The copolymerization ratio of the soft segment is preferably 1% by mol or more, more preferably 5% by mol or more, further preferably 10% by mol or more and particularly preferably 20% by mol or more, based on 100% by mol of the total glycol components constituting the copolymer polyester elastomer (X). In addition, the copolymerization ratio of the soft segment is preferably 90% by mol or less, more preferably 55% by mol or less, further preferably 50% by mol or less, and particularly preferably 45% by mol or less. When the copolymerization ratio of the soft segment is too low, it tends to cause problems that the melt viscosity of the resin composition of the present invention is increased, thus the copolymer polyester elastomer (X) cannot be molded at low pressure, or the crystallization rate is high to cause a short shot, and the like. In addition, the copolymerization ratio of the soft segment is too high, and it tends to cause problems that heat resistance of the sealed body of the present invention is insufficient, and the like.

The number average molecular weight of the soft segment is not particularly limited, but is preferably 400 or more, and more preferably 800 or more. When the number average molecular weight of the soft segment is too low, flexibility cannot be imparted, and it tends to cause a problem that the stress load to an electronic substrate after sealing is increased. In addition, the number average molecular weight of the soft segment is preferably 5000 or less, and more preferably 3000 or less. When the number average molecular weight is too high, it tends to cause a problem that compatibility with other copolymer components is low, thus the soft segment cannot be copolymerized.

The polycarbonate segment used in the soft segment includes those mainly consisting of a polycarbonate structure combined with an aliphatic diol residue having 2 to 12 carbon atoms at a carbonate group. In terms of flexibility and low temperature characteristics of the resulting polyester elastomer, an aliphatic diol residue having 4 to 12 carbon atoms is preferable, and an aliphatic diol residue having 5 to 9 carbon atoms is particularly preferable. The aliphatic diol residue may be used only one type, or may be used two or more types.

Specific examples of the polyalkylene glycol segments used in the soft segment include polyethylene glycol, polytrimethylene glycol, polytetramethylene glycol, and the like. Polytetramethylene glycol is most preferable in terms of imparting flexibility and reducing melt viscosity.

Specific examples of the polylactone segments used in the soft segment include polycaprolactone, polyvalerolactone, polypropiolactone, polyundecalactone, poly(1,5-oxetan-2-one), and the like.

### <Polyester resin (A)>

The polyester resin (A) used in the present invention is a crystalline polyester resin in which polyether diols are copolymerized, and is one of the copolymer polyester elastomers (X). The polyether diols are copolymerized, thereby exhibiting characteristics like reducing melt viscosity, imparting flexibility, and imparting bond property. The copolymerization ratio of the polyether diols is preferably 1% by mol or more, more preferably 5% by mol or more, further preferably 10% by mol or more, and particularly preferably 20% by mol or more, based on 100% by mol of the total glycol components constituting the crystalline polyester resin (A). In addition, the copolymerization ratio of the polyether diols is preferably 90% by mol or less, more preferably 55% by mol or less, further preferably 50% by mol or less, and particularly preferably 45% by mol or less. When the copolymerization ratio of the polyether diols is too low, it tends to cause problems that the melt viscosity is increased thus the crystalline polyester resin (A) cannot be molded at low pressure, or the crystallization rate is high to cause a short shot, and the like. In addition, the copolymerization ratio of the polyether diols is too high, and it tends to cause problems that heat resistance is insufficient, and the like. On the other hand, the number average molecular weight of the polyether diol is preferably 400 or more, and more preferably 800 or more. When the number average molecular weight of the polyether diol is too low, flexibility cannot be imparted, and it tends to cause a problem that the stress load to an electronic substrate after sealing is increased. In addition, the number average molecular weight of the polyether diol is preferably 5000 or less, and more preferably 3000 or less. When the number average molecular weight is too high, it tends to cause a problem that compatibility with other components is low, thus the polyether diol cannot be copolymerized. Specific examples of the polyether diols include polyethylene glycol, polytrimethylene glycol, polytetramethylene glycol, and the like. Polytetramethylene glycol is most preferable in terms of imparting flexibility and reducing melt viscosity.

In the constituent of the crystalline polyester resin (A) of the present invention, the composition ratio of aliphatic components and/or alicyclic components and aromatic components are adjusted, whereby the low melt viscosity that is not obtained from generic crystalline polyester resins such as polyethylene terephthalate (hereinafter may be abbreviated as PET) and polybutylene terephthalate (hereinafter may be abbreviated as PBT) generally used as an engineering plastics, heat resistance and high temperature and high moisture resistance comparable to a two-component curable epoxy resin, cooling and heating cycle resistance, and the like can be exhibited. For example, in order to maintain high heat resistance at 150°C or more, copolymer polyesters based on terephthalic acid and ethylene glycol, terephthalic acid and 1,4-butanediol, naphthalenedicarboxylic acid and ethylene glycol, and naphthalenedicarboxylic acid and 1,4-butanediol are suitable. Particularly, since mold-releasing property by rapid crystal solidification after molding is a desirable characteristic from the viewpoint of productivity, it is preferred that the copolymer polyester mainly consist of terephthalic acid and 1,4-butanediol, and naphthalenedicarboxylic acid and 1,4-butanediol, that are rapidly crystallized.

It is preferred that both or either of terephthalic acid and naphthalenedicarboxylic acid be contained as the acid component constituting the crystalline polyester resin (A), in terms of heat resistance. Also, as the copolymerization ratio thereof, the total of terephthalic acid and naphthalenedicarboxylic acid is preferably 65% by mol or more, further preferably 70% by mol or more, and particularly preferably 80% by mol or more, based on 100% by mol of the total amount of the acid components. When the total of terephthalic acid and naphthalenedicarboxylic acid is too low, heat resistance required for an electrical and electronic part may be insufficient.

In addition, as the glycol component constituting the crystalline polyester resin (A), it is preferred that both or either of ethylene glycol and 1,4-butanediol be contained in terms of crystallinity maintenance during copolymerization. Also, as the copolymerization ratio thereof, the total of ethylene glycol and 1,4-butanediol is preferably 40% by mol or more, further preferably 45% by mol or more, particularly preferably 50% by mol or more, and most preferably 55% by mol or more, based on 100% by mol of the total amount of the glycol components. When the total amount of ethylene glycol and 1,4-butanediol is too low, the crystallization rate is lowered, moldability is impaired such that mold-releasing property is deteriorated, and molding time is elongated, and further, crystallinity may be insufficient, and heat resistance may be insufficient.

In the polyester resin (A) of the present application, to a basic composition consisting of the acid component and glycol component described above that provides high heat resistance, aliphatic or alicyclic dicarboxylic acids such as adipic acid, azelaic acid, sebacic acid, 1,4-cyclohexanedicarboxylic acid, 1,3-cyclohexanedicarboxylic acid, 1,2-cyclohexanedicarboxylic acid, 4-methyl-1,2-cyclohexanedicarboxylic acid, dimer acid and hydrogenated dimer acid, aliphatic or alicyclic glycols such as 1,2-propanediol, 1,3-propanediol, 1,2-butanediol, 1,3-butanediol, 2-methyl-1,3-propanediol, 1,5-pentanediol, 1,6-hexanediol, 3-methyl-1,5-pentanediol, neopentyl glycol, diethylene glycol, dipropylene glycol, 2,2,4-trimethyl-1,3-pentanediol, cyclohexanedimethanol, tricyclodecanedimethanol, neopentylglycol hydroxypivalate ester, 1,9-nonanediol, 2-methyloctanediol, 1,10-dodecanediol, 2-butyl-2-ethyl-1,3-propanediol, polytetramethyleneglycol and polyoxymethyleneglycol can be used as a copolymer component, and bond property of the resin composition of the present invention may be able to be further improved.

In addition, when the polyester resin (A) of the present application is copolymerized with an aliphatic or alicyclic dicarboxylic acid having 10 or more carbon atoms such as dimer acid and hydrogenated dimer acid, and/or an aliphatic and/or alicyclic diol having 10 or more carbon atoms such as dimer diol and hydrogenated dimer diol, the glass transfer temperature is lowered while maintaining high melting point, compatibility of heat resistance and bond property to an electrical and electronic part of the resin composition of the present invention may be able to be further improved.

In addition, when the aliphatic or alicyclic dicarboxylic acid having 10 or more carbon atoms and/or an aliphatic or alicyclic diol having 10 or more carbon atoms like dimer acid and dimer diol, and a block-like segment consisting of an aliphatic component having comparatively high molecular weight represented by polyalkylene ether glycol like polytetramethylene glycol are introduced, cooling and heating cycle durability and hydrolysis resistance are respectively improved by lowering the glass transfer temperature of the polyester resin (A) and by reducing the ester group concentration, thus in the case where durability after molding is important, it is a more preferred measure. The cooling and heating cycle durability herein refers to a property that the separation in the interface of an electronic part and a sealing resin having different linear expansion coefficients or cracking of a sealing resin hardly occurs even if the temperature is increased and decreased many times between high temperature and low temperature. When the elastic modulus of the resin markedly increases during cooling, separation and cracking are likely to occur. In order to provide the material durable to cooling and heating cycles, the glass transfer temperature is preferably -10°C or less. The glass transfer temperature is more preferably -20°C or less, further preferably -40°C or less, and most preferably -50°C or less. The lower limit is not particularly limited, but considering bond property and blocking resistance, it is practically -100°C or more.

Herein, the dimer acid refers to an aliphatic or alicyclic dicarboxylic acid produced by dimerizing unsaturated fatty acids by polymerization, a Diels-Alder reaction or the like (containing mostly dimers, and several % by mol of trimers, monomers and the like, in many cases), and the hydrogenated dimer acid refers to an acid by adding hydrogen to the unsaturated linkage part of the dimer acid. In addition, the dimer diol and the hydrogenated dimer diol refer to those obtained by reducing two carboxyl groups of the dimer acid or the hydrogenated dimer acid to hydroxyl groups. Specific examples of the dimer acid and dimer diol include EMPOL (registered trademark) and SOVERMOL (registered trademark) from Cognis, Pripol from Uniqema, and the like.

On the other hand, in the polyester resin (A) of the present application, a small amount of an aromatic copolymer component can be also used within a range maintaining low melt viscosity. Examples of the preferred aromatic copolymer component include aromatic dicarboxylic acids such as isophthalic acid and orthophthalic acid, and aromatic glycols such as ethylene oxide adducts and propylene oxide adducts of bisphenol A. Particularly, an aliphatic component having comparatively higher molecular weight like dimer acid and dimer diol is introduced, whereby good mold-releasing property may be obtained by quick crystal solidification after molding.

In addition, in order to impart hydrolysis resistance durable to high temperature and high humidity for imparting long term durability to a sealed electrical and electronic part, the upper limit of the ester group concentration of the polyester resin (A) is desirably 8000 equivalent/10⁶ g. The upper limit is preferably 7500 equivalent/10⁶ g and more preferably 7000 equivalent/10⁶ g. In addition, for securing chemical resistance (to gasoline, engine oil, alcohol, general purpose solvent, and the like), the lower limit is desirably 1000 equivalent/10⁶ g. The lower limit is preferably 1500 equivalent/10⁶ g and more preferably 2000 equivalent/10⁶ g. Herein, the unit of the ester group concentration is expressed by the equivalent number per 10⁶ g of the resin, and is the value calculated from the composition of the polyester resin and the copolymerization ratio thereof.

When the aliphatic or alicyclic dicarboxylic acid having 10 or more carbon atoms and/or an aliphatic or alicyclic diol having 10 or more carbon atoms like dimer acid, hydrogenated dimer acid, dimer diol, and hydrogenated dimer diol are copolymerized to introduce a block-like segment into the polyester resin (A) of the present invention, the amount is preferably 2% by mol, further preferably 5% by mol, more preferably 10% by mol, and most preferably 20% by mol, based on 200% by mol of the total of the total acid components and the total glycol components of the polyester resin (A). Considering handling properties such as heat resistance and blocking, the upper limit is 70% by mol or less, preferably 60% by mol or less, and more preferably 50% by mol or less.

The number average molecular weight of the polyester resin (A) of the present invention is preferably 3000 or more, more preferably 5000 or more, and further preferably 7000 or more. In addition, the upper limit of the number average molecular weight is preferably 50000 or less, more preferably 40000 or less, and further preferably 30000 or less. When the number average molecular weight is less than 3000, hydrolysis resistance of the resin composition for sealing and high retention of elongation under high temperature and high humidity may be insufficient, and when the number average molecular weight is more than 50000, the melt viscosity at 220°C may be high.

The polyester resin (A) of the present invention is desirably a saturated polyester resin that does not contain an unsaturated group. In the case of an unsaturated polyester, there is a possibility such that crosslinking occurs upon melting, and may have poor melt stability.

In addition, the polyester resin (A) of the present invention may be a branched polyester obtained by copolymerizing polycarboxylic acids or polyols having three or more functional groups such as trimellitic anhydride and trimethylolpropane, as necessary.

Also, in order to mold the polyester resin (A) without causing thermal degradation as much as possible, rapid melting at 210 to 240°C is required, thus the upper limit of the melting point of the polyester resin (A) is desirably 210°C. The upper limit is preferably 200°C and more preferably 190°C. It is better if the lower limit is higher than the heat resistant temperature required by the corresponding purpose by 5 to 10°C. Considering handling properties at ordinary temperature and normal heat resistance, the upper limit is 70°C or more, preferably 100°C or more, further preferably 120°C or more, particularly preferably 140°C or more, and most preferably 150°C or more.

As the method for producing the polyester resin (A) of the present invention, a known method can be adopted, and for example, a target polyester resin can be obtained by esterifying the dicarboxylic acid described above and a diol component at 150 to 250°C, then polycondensing the reactant at 230 to 300°C while reducing the pressure. Alternatively, a target polyester resin can be obtained by esterifying using a derivative such as a dimethyl ester of the dicarboxylic acid described above and a diol component at 150°C to 250°C, then polycondensing the reactant at 230°C to 300°C while reducing the pressure.

Examples of the method for determining the composition and composition rate of the polyester resin (A) used in the present invention include ¹H-NMR and ¹³C-NMR determined by dissolving a polyester resin in a solvent such as heavy chloroform, quantitative analysis by gas chromatography determined after methanolysis of a polyester resin (hereinafter, may be abbreviated as methanolysis-GC method), and the like. In the present invention, in the case where there is a solvent that can dissolve the polyester resin (A) and is suitable for ¹H-NMR measurement, the composition and composition ratio shall be determined by ¹H-NMR. In the case where there is no suitable solvent, and in the case where the composition ratio cannot be specified only by ¹H-NMR measurement, ¹³C-NMR and methanolysis-GC method shall be adopted or concurrently used.

### <Brominated epoxy resin (B1) and non-brominated epoxy resin (B2)>

A brominated epoxy resin (B1) used in the resin composition of the present invention is an epoxy resin having an average of 1.1 or more of glycidyl group and 1 or more of bromine atom in a molecule. Examples include brominated bisphenol A diglycidyl ether, brominated novolac glycidyl ether, and the like, and also brominated glycidyl ester type, aliphatic or alicyclic brominated epoxide, and the like. Among them, particularly, in order to impart high bonding force and flame retardancy to an electrical and electronic part, those having good compatibility with the copolymer polyester elastomer (X) or the polyester resin (A) are preferred. The number average molecular weight of the brominated epoxy resin (B1) is preferably in the range of 100 to 10000, and when the number average molecular weight is less than 100, a sealant composition for an electrical and electronic part is very likely to be softened and has poor mechanical properties, and when the number average molecular weight is 10000 or more, compatibility with the copolymer polyester elastomer (X) or the polyester resin (A) is lowered, and bond property and flame retardancy may be impaired. Also, further increase of adhesion property can be expected and bleed out of the brominated epoxy resin (B1) from the sealant composition for an electrical and electronic part is suppressed by concurrently being used with the non-brominated epoxy resin (B2) shown below.

A non-brominated epoxy resin (B2) used in the resin composition of the present invention is an epoxy resin preferably having a number average molecular weight in the range of 450 to 40000, having an average of 1.1 or more of glycidyl group in a molecule. Examples of the non-brominated epoxy resin (B2) include glycidyl ether type such as bisphenol A diglycidyl ether, bisphenol S diglycidyl ether and novolac glycidyl ether, glycidyl ester type such as hexahydrophthalic glycidyl ester and dimer acid glycidyl ester, glycidyl amines such as triglicidyl isocyanurate, glycidylhydantoin, tetraglycidyl diamino diphenylmethane, triglycidyl para-aminophenol, triglycidyl meta-aminophenol, diglycidylaniline, diglycidyltoluidine, tetraglycidyl meta-xylenediamine, diglycidyltribromoaniline and tetraglycidyl bis(aminomethyl)cyclohexane, or aliphatic or alicyclic epoxides such as 3,4-epoxycyclohexylmethyl carboxylate, epoxidized polybutadiene and epoxidized soybean oil, and the like. In order to allow the sealant composition for an electrical and electronic part of the present invention to exhibit high bonding force to an electrical and electronic part, it is preferred to select one having good compatibility with the copolymer polyester elastomer (X) or the polyester resin (A) as the non-brominated epoxy resin (B2). In addition, the preferred number average molecular weight of the non-brominated epoxy resin (B2) is 450 to 40000. When the number average molecular weight of the non-brominated epoxy resin is less than 450, an bonding agent composition is very likely to be softened and has poor mechanical properties, and when the number average molecular weight is 40000 or more, compatibility with the copolymer polyester elastomer (X) or the polyester resin (A) is lowered, and bond property may be impaired.

In the present invention, the brominated epoxy resin (B1) and the non-brominated epoxy resin (B2) are blended in the resin composition for sealing, whereby the electrical and electronic parts can be made flame retardant while imparting excellent characteristics like good initial bond property and bond durability to a cooling and heating cycle and high moisture and high temperature environmental load.

The brominated epoxy resin (B1) is considered to exhibit, not only an effect as a flame resistor, but also a stress relaxation effect by retardation of crystallization of the polyester resin (A), an effect as a compatibilizer of the copolymer polyester elastomer (X) or the crystalline polyester resin (A) and the polyolefin resin (C), and further an effect of improving wettability to a substrate by introduction of a functional group.

The non-brominated epoxy resin (B2) and the brominated epoxy resin (B1) are concurrently used, whereby bleed out of the brominated epoxy resin (B1) from the resin composition for sealing electrical and electronic parts can be suppressed, and a stress relaxation effect by retardation of crystallization of the copolymer polyester elastomer (X) or the polyester resin (A), an effect as a compatibilizer of the crystalline polyester resin (A) and the polyolefin resin (C), and further an effect of improving wettability to a substrate by introduction of a functional group can be further added.

The total blending amount of the brominated epoxy resin (B1) and the non-brominated epoxy resin (B2) in the resin composition for sealing electrical and electronic parts of the present invention is preferably 5 to 100 parts by mass, based on 100 parts by mass of the copolymer polyester elastomer (X) or the polyester resin (A). When the total blending amount of the brominated epoxy resin (B1) and the non-brominated epoxy resin (B2) is less than 5 parts by mass, a stress relaxation effect by retardation of crystallization tends to decrease, and also a function as a compatibilizer of the polyolefin resin (C) and the epoxy resin (B) tends to decrease. In addition, when the total blending amount of the brominated epoxy resin (B1) and the non-brominated epoxy resin (B2) is 100 parts by mass or more, the productivity of the resin composition may be poor, and further, a sealed body may be poor in characteristics such as heat resistance.

When one having a chemical structure in common with the brominated epoxy resin (B1) as the non-brominated epoxy resin (B2) is used, bleed out suppressing effect of the brominated epoxy resin (B1) tends to increase, and is more preferable. For example, when a brominated bisphenol A type epoxy resin as a (B1) component is used, a bisphenol A type epoxy resin is preferably used as a (B2) component, and when a novolac type brominated epoxy resin as a (B1) component is used, a novolac type epoxy resin is preferably used as a (B2) component. The blending ratio of the non-brominated epoxy resin (B2) is preferably 10% by weight or more and 50% by weight or less, based on the brominated epoxy resin (B1). When the blending ratio of the non-brominated epoxy resin (B2) is 10% by weight or less, bleed out suppressing effect possibly cannot be exhibited, and when the composition ratio is 50% by weight or more, flame retardancy possibly cannot be exhibited.

### <Polyolefin resin (C)>

In the present invention, by blending the polyolefin resin (C) in the resin composition for sealing, when sealing electrical and electronic parts, excellent characteristics like good bond property and bond durability to a cooling and heating cycle and high temperature and hard environmental load are exhibited. The polyolefin resin (C) is considered to exhibit an effect of relaxing strain energy generated by crystallization of the copolymer polyester elastomer (X) or the polyester resin (A) and relaxation of enthalpy. The blending amount of the polyolefin resin (C) in the present invention is 0.1 to 100 parts by weight and preferably 0.5 to 50 parts by mass, based on 100 parts by weight of the copolymer polyester elastomer (X) or the polyester resin (A). When the polyolefin resin (C) is less than 0.5 parts by mass, crystallization of the copolymer polyester elastomer (X) or the polyester resin (A) and strain energy by enthalpy relaxation are difficult, thus bond strength tends to be lowered. Also, when the polyolefin resin (C) is blended in an amount of 50 parts by mass or more, bond property and resin physical properties tend to be conversely lowered. In addition, the copolymer polyester elastomer (X) or the polyester resin (A) and the polyolefin resin (C) cause macro phase separation to lower elongation at break, and it may adversely affect on moldability such that a smooth surface is not obtained.

The polyolefin resin (C) used in the present invention preferably has a density of 0.75 g/cm³ or more and less than 0.91 g/cm³. By using such very low density polyolefin, the copolymer polyester elastomer (X) or the polyester resin (A) that is originally incompatible, the polyolefin resin (C) can be easily and finely dispersed and mixed, and without requiring a special kneading equipment, for example, a homogeneous resin composition can be obtained by a general kneading equipment such as a single-screw extruder or a twin-screw extruder. In addition, due to low density and low crystallinity, the polyolefin resin (C) properly acts on relaxation of residual stress over time at injection molding generated in the copolymer polyester elastomer (X) or the crystalline polyester resin (A), and exhibits preferable characteristics like imparting of long-term bond durability, and reduction in generated stress by environmental load as a sealing resin. As the polyolefin resin (C) having such characteristics, polyethylene and an ethylene copolymer are particularly preferred since these are easily availability, inexpensive, and adversely affect on bond property to metals and films. Specifically, the polyolefin resin (C) includes low density polyethylenes, very low density polyethylenes, linear low density polyethylenes, ethylene propylene elastomers, ethylene-vinyl acetate copolymers, ethylene-ethyl acrylate copolymers, ethylene-vinyl acetate-maleic anhydride terpolymers, ethylene-ethyl acrylate-maleic anhydride terpolymers, ethylene-glycidyl methacrylate copolymers, ethylene-vinyl acetate-glycidyl methacrylate terpolymers, and ethylene-methyl acrylate-glycidyl methacrylate terpolymers.

In addition, the polyolefin resin (C) is preferably one that does not contain a polar group that can react with a polyester resin (A) such as a carboxyl group and a glycigyl group. When a polar group is present, compatibility of the copolymer polyester elastomer (X) or the polyester resin (A) varies, and strain energy at crystallization of the copolymer polyester elastomer (X) or the polyester resin (A) may not be able to be relaxed. Generally, a polyolefin having a polar group tends to have high compatibility with a polyester resin as compared to a polyolefin having no polar group, but in the present invention, when compatibility is increased, the decrease in bond property over time rather tends to be significant.

### <Phenol resin and/or phenol-modified alkyl benzene resin (D)>

Component (D) used in the present invention is a phenol resin (D1) and/or a phenol-modified alkyl benzene resin (D2). In the resin composition for an electrical and electronic part of the present invention, both or either of the phenol-modified alkyl benzene resin (D2) and/or the phenol resin (D1) can be used. The blending ratio is preferred that the total of the phenol-modified alkyl benzene resin (D2) and/or the phenol resin (D1) is 0 to 50 parts by mass, based on 100 parts by mass of the polyester resin. The component (D1) and the component (D2) are not an essential component, but by adding these components, an effect of suppressing bleed out of the brominated epoxy resin (B1) and/or an effect of improving bond property of the resin composition of the present invention to an electrical and electronic part as a sealing subject may be able to be exhibited. Particularly, in the case where similarity in the chemical structure of the brominated epoxy resin (B1) and the non-brominated epoxy resin (B2) is poor, a marked bleed out suppressing effect tends to be exhibited.

The phenol-modified alkyl benzene resin (D2) used in the resin composition of the present invention is one that an alkyl benzene resin is modified with phenol and/or alkyl phenol, and preferably has a number average molecular weight in the range of 450 to 40,000. The phenol-modified alkyl benzene resin (D2) can be produced, for example, by reacting an alkyl benzene such as xylene and mesitylene and an aldehyde such as formaldehyde in the presence of an acid catalyst to produce an alkyl benzene resin, and reacting the resulting resin with a phenol and an aldehyde in the presence of an acid catalyst. The phenol-modified alkyl benzene resin (D2) is preferably an alkyl phenol-modified xylene resin or an alkyl phenol-modified mesitylene resin. The xylene resin refers to a multimer composition of a basic structure in which xylene structures are cross-linked with methylene groups and ether bonds, and typically can be obtained by meta-xylene and formaldehyde are heated in the presence of a sulfuric acid. The methylene resin refers to a multimer composition of a basic structure in which methylene structures are cross-linked with methylene groups and ether bonds, and typically can be obtained by methylene and formaldehyde are heated in the presence of a sulfuric acid. The xylene resin and the methylene resin are a typical alkyl benzene resin. In addition, the phenol-modified alkyl benzene resin (D2) of the present invention has a hydroxyl value of preferably 100 equivalent/10⁶ g or more, more preferably 1000 equivalent/10⁶ g or more, and further preferably 5000 equivalent/10⁶ g or more. In addition, the hydroxyl value is preferably 20000 equivalent/10⁶ g or less and more preferably 15000 equivalent/10⁶ g or less. When the hydroxyl value is too low, bond property to an aluminum material tends to be lowered, and when the hydroxyl value is too high, water absorbency tends to increase and insulation property tends to lower. The hydroxyl value herein referred to is those measured according to JIS K 1557-1: 2007A method.

The phenol resin (D1) used in the resin composition of the present invention is a resin obtained by a reaction of a phenol and an aldehyde, may be a novolac type phenol resin or a cresol type phenol resin, and preferably has a number average molecular weight in the range of 450 to 40,000. Phenols that can be used as a starting material of the phenol resin include bifunctional phenols such as o-cresol, p-cresol, p-tert-butylphenol, p-ethyl phenol, 2,3-xylenol and 2,5-xylenol, trifunctional phenols such as phenol, m-cresol, m-ethylphenol, 3,5-xylenol and m-methoxy phenol, tetrafunctional phenols such as bisphenol A and bisphenol F, and a combined use of one or two or more types of those various phenols. In addition, as formaldehydes used in the production of a phenol resin, one or two or more types of formaldehyde, paraformaldehyde, trioxane and the like can be concurrently used. Besides, phenol-modified resins such as phenol aralkyl and phenol-modified xylene resins are cited. Among them, particularly, in order to exhibit high bond force, it is preferred to select one having good compatibility with the polyester resin (A). In order to obtain a phenol resin having good compatibility with the copolymer polyester elastomer (X) or the polyester resin (A), it is preferred to have a close melt viscosity and have a hydroxyl group. In addition, the phenol resin (D1) of the present invention has a hydroxyl value of preferably 100 equivalent/10⁶ g or more, more preferably 500 equivalent/10⁶ g or more, and further preferably 1000 equivalent/10⁶ g or more. In addition, the hydroxyl value is preferably 10000 equivalent/10⁶ g or less and more preferably 5000 equivalent/10⁶ g or less. When the hydroxyl value is too low, bond property to an aluminum material tends to be lowered, and when the hydroxyl value is too high, water absorbency tends to increase and insulation property tends to lower. The hydroxyl value herein referred to is those measured according to JIS K 1557-1: 2007A method.

### <Resin composition for sealing electrical and electronic parts>

The resin composition for sealing electrical and electronic parts of the present invention comprises a copolymer polyester elastomer (X) or a crystalline polyester resin (A) in which polyether diols are copolymerized, a brominated epoxy resin (B1), a non-brominated epoxy resin (B2) and a polyolefin resin (C) and has a melt viscosity of 5 dPa·s or more and 3000 dPa·s or less when dried to a water content of 0.1% or less, heated to 220°C, subjected to a pressure of 1 MPa, and then extruded from a die having a hole diameter of 1.0 mm and a thickness of 10 mm. In addition, it is preferred that, based on 100 parts by mass of a copolymer polyester elastomer (X) or a crystalline polyester resin (A), a total of 5 to 100 parts by mass of a brominated epoxy resin (B1) and a non-brominated epoxy resin (B2), 0.1 to 100 parts by mass of a polyolefin resin (C), and 0 to 50 parts by mass of a phenol resin (D1) and/or a phenol-modified xylene resin (D2) be contained, and the non-brominated epoxy resin (B2) be blended in 10% by mass or more and 50% by mass or less of the brominated polyester resin (B1).

The resin composition for sealing electrical and electronic parts of the present invention desirably has a melt viscosity at 220°C of 5 to 3000 dPa·s, and it can be achieved by properly adjusting the type and the blending ratio of the copolymer polyester elastomer (X) or the crystalline polyester resin (A), the brominated epoxy resin (B1), the non-brominated epoxy resin (B2), the polyolefin resin (C), and the phenol resin (D1) and/or the phenol-modified xylene resin (D2). For example, increase in the copolymerization ratio of the polyether diols copolymerized with the crystalline polyester resin (A) and lowering of the molecular weight of the crystalline polyester resin (A) tend to act in the direction of lowering the melt viscosity of the resin composition of the present invention, and increase in the molecular weight of the crystalline polyester (A) tends to act in the direction of increasing the melt viscosity of the resin composition of the present invention. Here, the melt viscosity at 220°C is a value measured as below. More specifically, the melt viscosity is a measured value of the viscosity when a resin composition for sealing is dried to a water content of 0.1% or less, subsequently, the resin composition for sealing warmed and stabilized at 220°C is passed through a die having a thickness of 10 mm having a hole diameter of 1.0 mm at a pressure of 98 N/cm², by a flow tester (model CFT-500C) manufactured by SHIMADZU CORPORATION. At a high melt viscosity of 3000 dPa·s or more, high resin cohesive force and durability are obtained, and injection molding is required at high pressure when sealing to a complex shape part, thus the part may be broken. A resin composition for sealing having a melt viscosity of 1500 dPa·s or less, preferably 1000 dPa·s or less, and more preferably 800 dPa·s or less, whereby, at a relatively low injection pressure of 0.1 to 100 MPa, a mold part having excellent electric insulation is obtained, and also characteristics of the electrical and electronic part are not impaired. In addition, from the viewpoint of an operation of injecting a resin composition for sealing, the lower melt viscosity at 220°C is preferable, but considering bond property and cohesive force of the resin composition, the lower limit is desirably 5 dPa·s or more, further preferably 10 dPa·s or more, more preferably 50 dPa·s or more, and most preferably 100 dPa·s or more.

### <Other constituents>

It is perfectly acceptable if resins other than the copolymer polyester elastomer (X), the polyester resin (A), the brominated epoxy resin (B1), the non-brominated epoxy resin (B2) and the polyolefin resin (C), such as polyesters, polyamides, polyolefins, epoxys, polycarbonates, acryls, ethylene vinyl acetates and phenols, curing agents such as isocyanate compounds and melamine, fillers such as talc and mica, pigments such as carbon black and titanium oxide, flame resistors other than (B1) such as antimony trioxide and brominated polystyrene are blended to the resin composition for sealing electrical and electronic parts of the present invention, as components other than (X) or (A), (B1), (B2) and (C), for the purpose of improving bond property, flexibility, durability and the like. The polyester resin (A) at that time is preferably 40% by weight or more and more preferably 50% by weight or more, based on the total composition. When the content of the copolymer polyester elastomer (X) or the polyester resin (A) is less than 40% by weight, bond property, bond durability, elongation retention, hydrolysis resistance and water resistance to an excellent electrical and electronic part, that are exhibited by the copolymer polyester elastomer (X) or the polyester resin (A) itself, may be lowered.

In the case where the sealed electrical and electronic part of the present invention is exposed to a high temperature and high humidity environment for a long time, an antioxidant is preferably added to the resin composition for sealing electrical and electronic parts of the present invention. Examples of preferred antioxidants include, as hindered phenol-based antioxidants, 1,3,5-tris(3,5-di-t-butyl-4-hydroxybenzyl) isocyanurate, 1,1,3-tri(4-hydroxy-2-methyl-5-t-butylphenyl) butane, 1,1-bis(3-t-butyl-6-methyl-4-hydroxyphenyl) butane, 3,5-bis(1,1-dimethylethyl)-4-hydroxy-benzenepropanoic acid, pentaerythrityl tetrakis(3,5-di-t-butyl-4-hydroxyphenyl) propionate, 3-(1,1-dimethylethyl)-4-hydroxy-5-methyl-benzenepropanoic acid, 3,9-bis[1,1-dimethyl-2-[(3-t-butyl-4-hydroxy-5-methylphenyl)propionyloxy]et hyl]-2,4,8,10-tetraoxaspiro[5.5]undecane and 1,3,5-trimethyl-2,4,6-tris(3',5'-di-t-butyl-4'-hydroxybenzyl) benzene, as phosphorus-based antioxidants, 3,9-bis(p-nonylphenoxy)-2,4,8,10-tetraoxa-3,9-diphosphataspiro[5.5]undecan e, 3,9-bis(octadecyloxy)-2,4,8,10-tetraoxa-3,9-diphosphaspiro[5.5]undecane, tri(monononylphenyl) phosphite, triphenoxyphosphine, isodecyl phosphite, isodecyl phenyl phosphite, diphenyl 2-ethylhexyl phosphite, dinonylphenyl bis(nonylphenyl)ester phosphorous acid, 1,1,3-tris(2-methyl-4-ditridecylphosphite-5-t-butylphenyl) butane, tris(2,4-di-t-butylphenyl) phosphite, pentaerythritol bis(2,4-di-t-butylphenyl phosphite), 2,2'-methylenebis(4,6-di-t-butylphenyl) 2-ethylhexyl phosphite and bis(2,6-di-t-butyl-4-methylphenyl) pentaerythritol diphosphite, and as thioether-based antioxidants, 4,4'-thiobis[2-t-butyl-5-methylphenol] bis[3-(dodecylthio) propionate], thiobis[2-(1,1-dimethylethyl)-5-methyl-4,1-phenylene] bis[3-(tetradecylthio)-propionate], pentaerythritol tetrakis(3-n-dodecylthiopropionate), bis(tridecyl) thiodipropionate, and these can be used alone or in form of a composite. The amount added is preferably 0.1% by weight or more and 5% by weight or less, based on the total resin composition for sealing. When the amount is less than 0.1% by weight, deterioration prevention effect may become poor. Also, when the amount exceeds 5% by weight, it may adversely affect on bond property or the like.

### <Method for producing sealed electrical and electronic part>

The sealed electrical and electronic part of the present invention can be produced by heating and kneading the resin composition for sealing electrical and electronic parts of the present invention and then injecting the resin composition into a mold including an inserted electrical and electronic part. Herein, the resin composition for sealing electrical and electronic parts of the present invention may be one that whole components constituting the resin composition are separately heated and kneaded in advance or may be one that a part or all of the constituents is mixed immediately before injection into the mold and heated and kneaded.

While the temperature of the resin composition and the pressure of the resin composition upon injection into the mold are not particularly limited, but a temperature of the resin composition of 130°C or more and 260°C or less and a pressure of the resin composition of 0.1 MPa or more and 10 MPa or less are preferred since damage to the electrical and electronic part is less. For injection of the resin, for example, a screw type hot melt applicator for molding can be used. The type of the hot melt applicator for molding is not particularly limited, and examples include ST2 manufactured by Nordson Corporation, a vertical extrusion molding machine manufactured by IMOTO MACHINERY CO., LTD., and the like.

### EXAMPLES

The present invention will be described in detail with reference to Examples and Comparative Examples, but the present invention is not limited by the Examples. Measured values described in the Examples and the Comparative Examples are those measured by the following methods.

### <Measurement of melting point and glass transfer temperature>

5 mg of a measurement sample was put in an aluminum pan, and the aluminum pan was sealed by pressing a lid, and once hold at 250°C for 5 minutes, then rapidly cooled with liquid nitrogen, thereafter determination was performed at a temperature rising rate of 20°C/min from -150°C to 250°C, with a differential scan calorimeter "Model DSC220" manufactured by Seiko Instruments Inc. The inflexion point and endothermic peak of the resulting curve were respectively defined as a glass transfer temperature and a melting point.

### <Measurement of ten-point average roughness>

Roughness was measured on arbitrary five points on surfaces of substrates 4 and 5 contacting with the sealing resin composition with a measurement length of 5 mm, using surftest 600 manufactured by Mitutoyo Corporation, and ten-point average roughness was calculated according to JIS B 0601-1994. Here, a stylus used in the measurement had the following specification.
Material of stylus tip end: Diamond
Shape of stylus tip end: 90° conical shape
Curvature radius of stylus tip end: 2 µm

### <Bond strength test>

### Method for preparing bond strength test piece

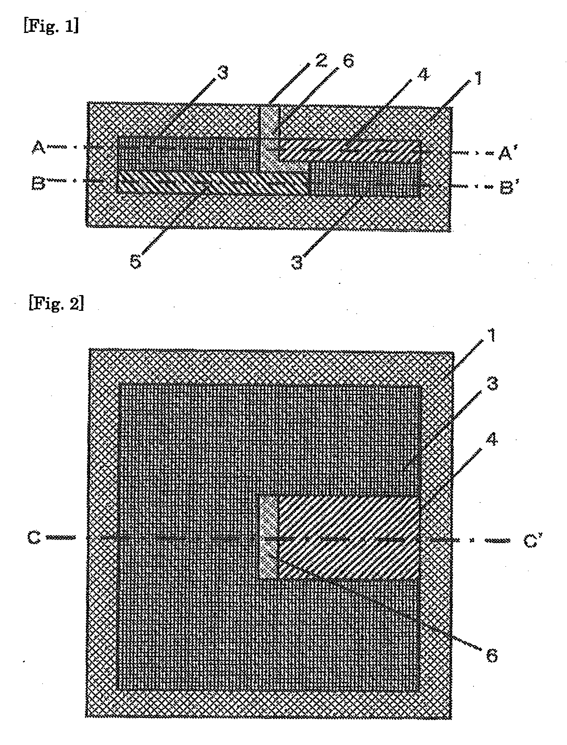

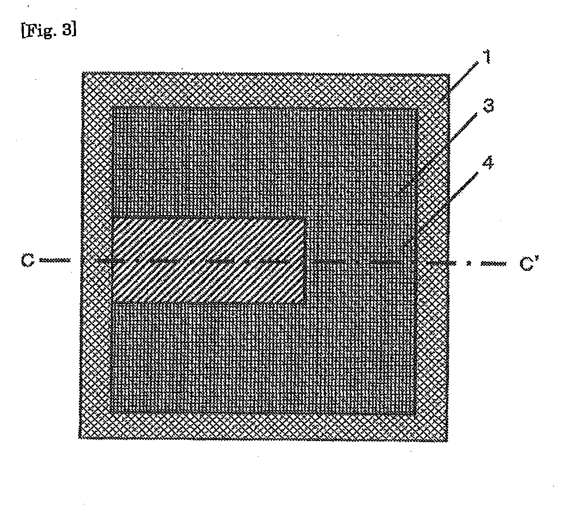

A substrate 4 (25 mm width × 48 mm length × 2 mm thickness) and a substrate 5 (25 mm width × 70 mm length × 2 mm thickness) made of FR-4 glass epoxy plate NIKAPLEX manufactured by NIKKAN INDUSTRIES CO., LTD. were disposed in a mold 1 for molding a flat plate (inside dimension of the mold: 100 mm width × 100 mm length × 5 mm thickness) together with a spacer 3. Subsequently, the resin composition for sealing was injected from a gate 2 using a screw type hot melt applicator for molding (a vertical extrusion molding machine manufactured by IMOTO MACHINERY CO., LTD.), and injection molding was performed. Injection molding conditions were set at a temperature of the molding resin of 220°C, a molding pressure of 3 MPa, a dwelling pressure of 3 MPa, a cooling time of 15 seconds, and an injection rate of 50%. Figs. 1 to 3 are a cross-sectional schematic view of the mold 1, and show states at the time of completing injection of the resin composition for sealing, and A-A' cross section in Fig. 1 is Fig. 2, B-B' cross section in Fig. 1 is Fig. 3, and C-C' cross section in Figs. 2 and 3 is Fig. 1. A molded article was released, and the resin composition for sealing other than an overlapping part of the substrate 4 and the substrate 5 was cut off, to obtain an bond strength test piece. Hereinafter, this test piece is called a glass epoxy bond test piece. The glass epoxy bond test piece has a structure in which the resin composition for sealing with 1 mm thickness is filled and adhered to an overlapping part (25 mm width × 18 mm length) of glass epoxy plates, and the adhesion area of the glass epoxy plate and the resin composition is 25 × 18 = 450 mm². Here, as the glass epoxy plate, one having a ten-point average roughness of the surface of an adhesive part within the range of 0.5 to 3 µm is used.

The bond test piece was left under an atmosphere of 23°C and 50% RH for 3 hours or more and 100 hours or less, then a tension was added to the longitudinal direction of the test piece to add a shear force, and the strength in breaking was measured. The tensile speed was 50 mm/min. The strength in breaking per bonding area (450 mm²) was defined as the shear bond strength.

### Evaluation criteria

⊚: Shear bond strength of 1.0 MPa or more
○: Shear bond strength of less than 1.0 MPa and 0.5 MPa or more
×: Shear bond strength of less than 0.5 MPa

### <Melting characteristic test>

### Method for evaluating melt viscosity of resin and resin composition for sealing

By a flow tester (Model CFT-500C) manufactured by SHIMADZU CORPORATION, a resin or resin composition for sealing dried to a water content of 0.1% or less was filled into a cylinder in the center of a heating body set at 220°C, and after the lapse of 1 minute of filling, a load was added to a sample via a plunger, and the melted sample was extruded from a die (hole diameter: 1.0 mm, thickness: 10 mm) at the bottom of the cylinder, at a pressure of 1 MPa, the distance and time of a descent of the plunger was recorded, to calculate the melt viscosity.

### <Low pressure moldability test>

Using a mold for molding a flat plate, a flat plate (100 mm × 100 mm × 10 mm) made from a resin composition for sealing was molded using ST-2 manufactured by Nordson Corporation as a hot melt applicator for molding. A gate position was the center of the surface of 100 mm × 100 mm.
Molding conditions: set at a temperature of the molding resin of 220°C, a molding pressure of 3 MPa, a dwelling pressure of 3 MPa, a cooling time of 15 seconds, an injection rate of 50%

### Evaluation criteria

○: The molded flat plate is completely filled, and no sink mark is generated.
Δ: The molded flat plate is filled with no short shot, but a sink mark is generated.
×: There is a short shot.

### <Flame retardant test>

According to the evaluation method of UL-94, flame retardancy of two types of flame retardant test pieces with 0.8 mm thickness and 1.6 mm thickness was evaluated.

### Molding conditions of the test pieces

a temperature of the molding resin of 220°C, a molding pressure of 10 MPa, a dwelling pressure of 10 MPa, a cooling time of 25 seconds, an injection rate of 20 g/sec.

### Evaluation criteria

○: Both of the two types of flame retardant test pieces described above are any of V0, V1 or V2
×: Either or both of the two types of flame retardant test pieces described above are not any of V0, V1 or V2.

### <Bleed out test>

The test piece prepared in the same manner as in the flame retardant test was allowed to stand still under environment at 25°C × 50% RH for 2 months, then the presence or absence of bleed out was visually confirmed, and the flame retardancy was evaluated by the method of the flame retardant test.

### Evaluation criteria

⊚: At the time of the lapse of 2 months, no bleed out can be visually confirmed, and flame retardancy after bleed out test is "○".
○: At the time of the lapse of 2 months, there is bleed out that can be visually confirmed, and flame retardancy after bleed out test is "○".
×: At the time of the lapse of 2 months, there is bleed out that can be visually confirmed, and flame retardancy after bleed out test is "×",

### <Production example of copolymer polyester elastomer>

To a reactor equipped with a stirrer, a thermometer and a condenser for distillation were added 166 parts by mass of terephthalic acid, 180 parts by mass of 1,4-butanediol, 0.25 parts by mass of tetrabutyl titanate, and esterification reaction was carried out at 170 to 220°C for 2 hours. After completing the esterification reaction, 300 parts by mass of polytetramethylene glycol "PTMG1000" (manufactured by Mitsubishi Chemical Corporation) having a number average molecular weight of 1000 and 0.5 parts by mass of "Irganox (registered trademark) 1330" (manufactured by Nihon Ciba-Geigy K.K.) were added thereto, and heated to 255°C while slowly reducing a pressure in the system, to reach to 665 Pa at 255°C for 60 minutes. Then, polycondensation reaction was further carried out at 133 Pa or less for 30 minutes, to obtain copolymer polyester elastomer A. The melting point of the copolymer polyester elastomer A was 165°C, and the melt viscosity was 250 dPa·s.

Copolymer polyester elastomers B to E were synthesized in the same manner as the copolymer polyester elastomer A. Compositions and physical property values of each copolymer polyester elastomer are shown in Tables 1 and 2.

**[Table 1]**

| copolymer polyester elastomer | | | A | B | C | D |
|---|---|---|---|---|---|---|
| mol % of component | dicarboxylic acid component | TPA | 100 | | | 100 |
| | | NDC | | 100 | 100 | |
| | diol component | BD | 72 | 60 | 58 | 60 |
| | | PTMG1000 | 28 | 40 | | |
| | | PTMG2000 | | | 42 | |
| | | polycaprolactone | | | | 40 |
| properties | melt viscosity dPa·s | | 250 | 400 | 400 | 1500 |
| | melting point °C | | 165 | 160 | 159 | 170 |
| | glass transition temperature °C | | -65 | -70 | -75 | -10 |

**[Table 2]**

| copolymer polyester elastomer | | E |
|---|---|---|
| mass % of copolymer component | polybutylene terephthalate | 100 |
| | polycarbonate diol | 40 |
| properties | melt viscosity dPa·s | 800 |
| | melting point °C | 190 |
| | glass transition temperature °C | -40 |

Abbreviations in Tables are as follows.

TPA : terephthalic acid, NDC : naphthalene dicarboxylic acid , BD : 1,4-butanediol, PTMG1000 : polytetramethylene ether glycol (the number average molecular weight is 1000), PTMG2000 : polytetramethylene ether glycol (the number average molecular weight is 2000).

### <Production examples of resin composition for sealing electrical and electronic parts>

A resin composition for sealing electrical and electronic parts 1 was obtained by homogeneously mixing 100 parts by mass of copolymer polyester elastomer A, 30 parts by mass of polyolefin resin A, 30 parts by mass of brominated epoxy resin A and 20 parts by mass of non-brominated epoxy resin A and then melting and kneading the mixture at a die temperature of 220°C using a twin-screw extruder. Resin compositions for sealing 2 to 22 were prepared in the same method as the resin composition for sealing 1. Compositions and physical property values of each resin composition were shown in Tables 3 to 6.

[Table 3]

| | | | Example 1 | Example 2 | Example 3 | Example 4 | Example 5 |
|---|---|---|---|---|---|---|---|
| name of resin composition for sealing | | | Composition 1 | Composition 2 | Composition 3 | Composition 4 | Composition 5 |
| | copolymer polyester elastomer (X) | copolymer polyester elastomer A | 100 | 100 | 100 | | |
| | | copolymer polyester elastomer B | | | | 100 | 100 |
| | | copolymer polyester elastomer C | | | | | |
| | | copolymer polyester elastomer D | | | | | |
| | | copolymer polyester elastomer E | | | | | |
| | brominated epoxy resin (B1) | brominated epoxy resin A | 20 | 20 | 20 | | |
| | | brominated epoxy resin B | | | | 30 | 30 |
| blend of resin composition (parts by mass) | non-brominated epoxy resin (B2) | non-brominated epoxy resin A | 10 | 10 | 10 | | |
| | | non-brominated epoxy resin B | | | | 10 | 5 |
| | | non-brominated epoxy resin C | | | | | |
| | polyolefin resin (C) | polyolefin resin A | 30 | | | 40 | 40 |
| | | polyolefin resin B | | 30 | | | |
| | | polyolefin resin C | | | 10 | | |
| | Phenol resin (D1) and/or phenol-modified alkyl benzene resin (D2) | phenol resin A | | | | | |
| | | phenol-modified alkyl benzene resin A | | | | | |
| melting characteristic | melt viscosity of resin composition dPa·s | | 554 | 660 | 957 | 729 | 749 |
| | low pressure moldability test | | ○ | ○ | ○ | ○ | ○ |
| bleed out test | | | ⊚ | ⊚ | ⊚ | ⊚ | ⊚ |
| bond strength test | | | ⊚ | ○ | ○ | ⊚ | ○ |
| flame retardant test | | | ○ | ○ | ○ | ○ | ○ |

[Table 4]

| Example | | | Example 6 | Example 7 | Example 8 | Example 9 | Example 10 |
|---|---|---|---|---|---|---|---|
| name of resin composition for sealing | | | Composition 6 | Composition 7 | Composition 8 | Composition 9 | Composition 10 |
| | copolymer polyester elastomer (X) | copolymer polyester elastomer A | | | 100 | | |
| | | copolymer polyester elastomer B | | | | 100 | |
| | | copolymer polyester elastomer C | 100 | 100 | | | 100 |
| | | copolymer polyester elastomer D | | | | | |
| blend of resin composition (parts by mass) | | copolymer polyester elastomer E | | | | | |
| | brominated epoxy resin (B1) | brominated epoxy resin A | | | 40 | | |
| | | brominated epoxy resin B | 20 | 20 | | 30 | 30 |
| | non-brominated epoxy resin (B2) | non-brominated epoxy resin A | | | 10 | | |
| | | non-brominated epoxy resin B | | | | 10 | 10 |
| | | non-brominated epoxy resin C | 10 | 5 | | | |
| | polyolefin resin (C) | polyolefin resin A | 40 | 40 | | | |
| | | polyolefin resin B | | | 30 | 40 | |
| | | polyolefin resin C | | | | | 10 |
| | Phenol resin (D1) and/or phenol-modified alkyl benzene resin (D2) | phenol resin A | | | | | |
| | | phenol-modified alkyl benzene resin A | | | | | |
| melting characteristic | melt viscosity of resin composition dPa·s | | 771 | 794 | 589 | 855 | 1025 |
| | low pressure moldability test | | ○ | ○ | ○ | ○ | ○ |
| bleed out test | | | ⊚ | ⊚ | ⊚ | ⊚ | ⊚ |
| bond strength test | | | ⊚ | ○ | ○ | ○ | ○ |
| flame retardant test | | | ○ | ○ | ○ | ○ | ○ |

[Table 5]

| | | | Example 11 | Example 12 | Example 13 | Example 14 | Example 15 | Example 16 | Example 17 |
|---|---|---|---|---|---|---|---|---|---|
| name of resin composition for sealing | | | Composition 11 | Composition 12 | Composition 13 | Composition 14 | Composition 15 | Composition 16 | Composition 17 |
| | copolymer polyester elastomer (X) | copolymer polyester elastomer A | 100 | 100 | 100 | 100 | 100 | | |
| | | copolymer polyester elastomer B | | | | | | | |
| | | copolymer polyester elastomer C | | | | | | | |
| | | copolymer polyester elastomer D | | | | | | 100 | |
| | | copolymer polyester elastomer E | | | | | | | 100 |
| blend of resin composition (parts by mass) | brominated epoxy resin (B1) | brominated epoxy resin A | | | | 30 | | 20 | 20 |
| | | brominated epoxy resin B | 5 | 30 | 30 | | 30 | | |
| | non-brominated epoxy resin (B2) | non-brominated epoxy resin A | | 5 | 10 | | | 10 | 10 |
| | | non-brominated epoxy resin B | 2.5 | | | | 5 | | |
| | | non-brominated epoxy resin C | | | | 10 | | | |
| | polyolefin resin (C) | polyolefin resin A | 40 | 40 | 40 | 40 | 40 | 30 | 30 |
| | | polyolefin resin B | | | | | | | |
| | | polyolefin resin C | | | | | | | |
| | Phenol resin (D1) and/or phenol-modified alkyl benzene resin (D2) | phenol resin A | | | | | 10 | | |
| | | phenol-modified alkyl benzene resin A | | 10 | | | | | |
| melting characteristic | melt viscosity of resin composition dPa·s | | 738 | 737 | 618 | 615 | 628 | 554 | 554 |
| | low pressure moldability test | | ○ | ○ | ○ | ○ | ○ | ○ | ○ |
| bleed out test | | | ⊚ | ⊚ | ○ | ○ | ⊚ | ⊚ | ⊚ |
| bond strength test | | | ○ | ⊚ | ⊚ | ⊚ | ⊚ | ⊚ | ⊚ |
| flame retardant test | | | ○ | ○ | ○ | ○ | ○ | ○ | ○ |

[Table 6]

| | | | Comparative Example 1 | Comparative Example 2 | Comparative Example 3 | Comparative Example 4 | Comparative Example 5 |
|---|---|---|---|---|---|---|---|
| name of resin composition for sealing | | | Composition 18 | Composition 19 | Composition 20 | Composition 21 | Composition 22 |
| | copolymer polyester elastomer (X) | copolymer polyester elastomer A | 100 | 100 | | 100 | 100 |
| | | copolymer polyester elastomer B | | | 100 | | |
| | | copolvmer polyester elastomer C | | | | | |
| | | copolymer polyester elastomer D | | | | | |
| | | copolymer polyester elastomer E | | | | | |
| blend of resin composition (parts by mass) | brominated epoxy resin (B1) | brominated epoxy resin A | 30 | | | | |
| | | brominated epoxy resin B | | | 20 | 30 | |
| | non-brominated epoxy resin (B2) | non-brominated epoxy resin A | | 30 | | | |
| | | non-brominated epoxy resin B | | | | | 30 |
| | | non-brominated epoxy resin C | | | 5 | | |
| | polyolefin resin (C) | polyolefin resin A | 30 | 30 | | 30 | 30 |
| | | polyolefin resin B | | | | | |
| | | polyolefin resin C | | | 45 | | |
| | Phenol resin (D1) and/or phenol-modified alkyl benzene resin (D2) | phenol resin A | | | | | |
| | | phenol-modified alkyl benzene resin A | | | | | |
| melting characteristic test | melt viscosity of resin composition dPa·s | | 554 | 553 | 3237 | 552 | 553 |
| | low pressure moldability test | | ○ | ○ | × | ○ | ○ |
| bleed out test | | | × | ○ | ○ | × | ○ |
| bond strength test | | | ○ | ○ | ○ | ○ | ○ |
| flame retardant test | | | ○ | × | ○ | ○ | × |

The components used in Tables 3 to 6 are as described below.
Polyolefin resin A: EXCELLEN (registered trademark) VL EUL731, manufactured by SUMITOMO CHEMICAL Co., Ltd., α-olefin copolymer very low density polyethylene, density of 0.90.
Polyolefin resin B: ADMER (registered trademark) SF-600, manufactured by Mitsui Chemicals, Inc., adhesive polyolefin, density of 0.88.
Polyolefin resin C: HI-ZEX (registered trademark) 2100J, manufactured by Mitsui Chemicals, Inc., high density polyethylene, density of 0.93.
Brominated epoxy resin A: BREN-S, manufactured by Nippon Kayaku Co., Ltd., brominated novolac type epoxy resin
Brominated epoxy resin B: JER5050, manufactured by Mitsubishi Chemical Corporation, brominated bisphenol A type epoxy resin
Non-brominated epoxy resin A: YDCN-704A, manufactured by Nippon Steel Chemical Co., Ltd., novolac type epoxy resin
Non-brominated epoxy resin B: JER1007K, manufactured by Mitsubishi Chemical Corporation, bisphenol A type epoxy resin
Non-brominated epoxy resin C: YD-017, manufactured by Nippon Steel Chemical Co., Ltd., bisphenol A type epoxy resin
Phenol-modified alkyl benzene resin A: HP-150, manufactured by MITSUBISHI GAS CHEMICAL COMPANY, INC.
Phenol resin A: EP4020, manufactured by Asahi Organic Chemicals Industry Co., Ltd., cresol novolac type phenol resin.

### Example 1

Using the resin composition for sealing 1 as the resin composition for sealing, <Melting characteristic test>, <Bond strength test>, <Bleed out test>, <Low pressure moldability test>, and <Flame retardant test> were performed. In the <Melting characteristic test>, melting characteristic was good as 554dPa·s. In the <Bond strength test>, as a glass epoxy plate bond test piece, an initial bond strength was 1.3 MPa. The results were good in all items such that <Flame retardant test> was equivalent to V2, in the <Bleed out test>, there was no bleed out by visual confirmation and flame retardancy after bleed out test also maintained V2 or more, and <Low pressure moldability test> was good without having a sink mark and a short shot. The evaluation results were shown in Table 3.

### Examples 2 to 17

Using the resin compositions for sealing 2 to 17 as the resin composition for sealing, <Melting characteristic test>, <Bond strength test>, <Bleed out test>, <Low pressure moldability test>, and <Flame retardant test> were performed in the same manner as in Example 1. The evaluation results were shown in Tables 3 to 5.

### Comparative Example 1

Using the resin composition for sealing 16 as the resin composition for sealing, <Melting characteristic test>, <Bond strength test>, <Bleed out test>, <Low pressure moldability test>, and <Flame retardant test> were performed in the same manner as in Example 1. In the <Melting characteristic test>, the result was 554 dPa·s, and also in the <Bond strength test>, the result of the adhesion strength to a glass epoxy plate was good as 1.0 MPa. Also in the <Flame retardant test>, the result was good as equivalent to V2, but in the <Bleed out test>, bleed out was visually confirmed to be NG in the evaluation result.

### Comparative Examples 2 to 5

Using the resin compositions for sealing 18 to 22 as the resin composition for sealing, <Melting characteristic test>, <Bond strength test>, <Bleed out test>, <Low pressure moldability test>, and <Flame retardant test> were performed in the same manner as in Example 1. The evaluation results were shown in Table 6.

Examples 1 to 17 satisfy Claims, and all results of <Melting characteristic test>, <Bond strength test>, <Bleed out test>, <Low pressure moldability test>, and <Flame retardant test> were good. On the other hand, Comparative Example 1 did not contain a non-brominated epoxy resin, thus was outside the scope of the present invention, and the result of <Bleed out test> was poor. In addition, Comparative Examples 2 and 5 did not contain a brominated epoxy resin, thus was outside the scope of the present invention, and the flame retardant test was poor as HB. Comparative Example 3 had high melt viscosity and was outside the scope of the present invention, and the low pressure moldability was poor. Comparative Example 4 did not contain a non-brominated epoxy resin as same as Comparative Example 1, thus was outside the scope of the present invention, and the flame retardant test was poor as equivalent to HB.

### INDUSTRIAL APPLICABILITY

The resin composition for sealing electrical and electronic parts of the present invention can provide a flame-retardant sealed electrical and electronic part wherein there is no bleed out of the flame resistor but filling with a sealant and adhesion between the sealant and electrical or electronic part are sufficient for practical use, for example, is useful as a sealant used for a sealed electrical and electronic part, for example, for cars, communication, computer, various connectors, harnesses or electronic parts for household application, switches and sensors having a printed circuit board.

### DESCRIPTION OF THE NUMERALS

- 1: mold
- 2: gate
- 3: spacer
- 4,5: substrate
- 6: resin composition

## Claims

1. A resin composition for sealing electrical and electronic parts, comprising a copolymer polyester elastomer (X), a brominated epoxy resin (B1), a non-brominated epoxy resin (B2) and a polyolefin resin (C), and having a melt viscosity of 5 dPa·s or more and 3.0 × 10³ dPa·s or less when dried to a water content of 0.1% or less, heated to 220°C, subjected to a pressure of 1 MPa, and then extruded from a die having a hole diameter of 1.0 mm and a thickness of 10 mm.

2. A resin composition for sealing electrical and electronic parts, comprising a crystalline polyester resin (A) in which polyether diols are copolymerized, a brominated epoxy resin (B1), a non-brominated epoxy resin (B2) and a polyolefin resin (C), and having a melt viscosity of 5 dPa·s or more and 3000 dPa·s or less when dried to a water content of 0.1% or less, heated to 220°C, subjected to a pressure of 1 MPa, and then extruded from a die having a hole diameter of 1.0 mm and a thickness of 10 mm.

3. The resin composition for sealing electrical and electronic parts according to claim 1 or 2, wherein both brominated the epoxy resin (B1) and the non-brominated epoxy resin (B2) are a bisphenol A type or a novolac type epoxy resin.

4. The resin composition for sealing electrical and electronic parts according to any of claims 1 to 3, comprising 100 parts by mass of the copolymer polyester elastomer (X) or the crystalline polyester resin (A), a total of 5 to 100 parts by mass of the brominated epoxy resin (B1) and the non-brominated epoxy resin (B2) and 0.1 to 100 parts by mass of a polyolefin resin (C), wherein the non-brominated epoxy resin (B2) is blended in 10% by mass or more and 50% by mass or less of the brominated epoxy resin (B1).

5. The resin composition for sealing electrical and electronic parts according to any of claims 1 to 4, further comprising a phenol resin and/or phenol-modified alkyl benzene resin (D).

6. A method for producing a sealed electrical and electronic part, comprising heating and kneading the resin composition according to any of claims 1 to 5, and thereafter injecting the resin composition into a mold including an inserted electrical and electronic part at a resin composition temperature of 130°C or more and 260°C or less and at a resin composition pressure of 0.1 MPa or more and 10 MPa or less.

7. A sealed electrical and electronic part sealed with the resin composition as defined in any of claims 1 to 5.
